# EUROPÄISCHE PATENTSCHRIFT

(11) **EP 0 828 411 B1**
(45) Veröffentlichungstag und Bekanntmachung des Hinweises auf die Patenterteilung: **10.11.1999**
(21) Anmeldenummer: 97202640.5
(22) Anmeldetag: 28.08.1997
(51) Int. Cl.: H05K 9/00

(54) **Abschirmgehäuse für elektronische Bauelemente**
Shielded enclosure for electronic components
Boîte écran pour composants électroniques

(30) Priorität: 06.09.1996 DE 19636182
(43) Veröffentlichungstag der Anmeldung: 11.03.1998
(73) Patentinhaber: Philips Patentverwaltung GmbH, 22335 Hamburg (DE); Koninklijke Philips Electronics N.V., 5621 BA Eindhoven (NL)
(72) Erfinder: Matuschik, Peter, Röntgenstrasse 24, 22335 Hamburg (DE)
(74) Vertreter: Schmalz, Günther, Dipl.-Ing.

(56) Entgegenhaltungen:
- US-A- 5 436 802

## Beschreibung

Die Erfindung bezieht sich auf ein Abschirmgehäuse für im Innern angeordnete elektronische Bauelemente mit einer durch einen Deckel verschlossenen Gehäuseöffnung, die einen umlaufenden, nach innen abgewinkelten Gehäuserand aufweist, wobei durch Aussparungen gebildete, nach außen ragende Zungen des Deckels nach innen ragende Vorsprünge des Gehäuserandes untergreifen. Die Erfindung bezieht sich ferner auf ein Verfahren zur Abschirmung von in einem derartigen Gehäuse angeordneten elektronischen Bauelementen.

Ein Abschirmgehäuse der eingangs genannten Art ist z.B. durch die US-PS 54 36 802 bekannt geworden. Die bekannte Bauart zeigt eine Anordnung zur Abschirmung eines elektrischen Schaltkreises, der auf einem Substrat angeordnet ist. Dabei wird das an seiner Oberseite durch einen Deckel verschließbare Gehäuse mit seiner unten offenen Seite derart auf das Substrat aufgesetzt, daß eine elektrische Verbindung mit den Wänden des Gehäuses erfolgt. Der Deckel wird dabei auf die andere offene Seite des Gehäuses aufgesetzt, und zwar auf den nach innen abgewinkelten Gehäuserand. Zur Befestigung dieses Deckels wird dieser zunächst auf den Gehäuserand so aufgesetzt, daß die in einer Ebene unterhalb der Deckelebene liegenden Zungen in entsprechende Aussparungen des Gehäuserandes eingreifen. Sodann wird der Deckel so verschoben, daß die Zungen entsprechende Vorsprünge des Geäuserandes untergreifen. Bei dieser Bauart liegt somit der Deckel auf dem Gehäuse auf und wird durch die die Vorsprünge untergreifenden Zungen festgehalten.

Der Erfindung liegt die Aufgabe zugrunde, das Abschirmgehäuse der eingangs genannten Art hinsichtlich des Aufbaues und der Montage zu vereinfachen.

Diese Aufgabe wird gemäß der Erfindung dadurch gelöst,
- daß die Zungen des Deckels und die Vorsprünge des Gehäuserandes jeweils an zwei gegenüberliegenden Seiten angeordnet sind,
- daß die Zungen des Deckels mit dem Deckel in ein und derselben Ebene liegen,
- daß neben den Vorsprüngen nach unten abgewinkelte Balkone zur Auflage des Deckels vorgesehen sind und
- daß die beiden von Zungen freien Kanten des Deckels die beiden entsprechenden Gehäuseränder untergreifen.

Damit ist eine äußerst flache Bauweise des Gehäuses ermöglicht, da der Deckel nicht mehr auf dem Gehäuse aufliegt, sondern in das Gehäuse eingelassen ist und somit nicht mehr vorsteht. Der Deckel verschwindet somit völlig in dem Gehäuse. Dadurch, daß die durch die Aussparungen gebildeten Zungen in ein und derselben Ebene mit dem Deckel liegen, ist der Deckel in sich stabiler und fester als bei einer Bauart, bei der die Zungen aus der Ebene des Deckels herausgebogen werden. Dies bedeutet, daß die Zungen ihre Elastizität auch bei mehrfachem Ein- und Ausschieben zuverlässig behalten. Bei der Bauart gemäß der Erfindung sind Zungen bzw. Vorsprünge nur an zwei gegenüberliegenden Seiten erforderlich, da die beiden anderen, von Zungen freien Kanten des Deckels unter die entsprechenden Gehäuseränder geschoben sind. Dies bedeutet, daß der Deckel an den Seiten, an welchen keine Zungen vorhanden sind, etwas länger ist als die Gehäuseöffnung. Die nach unten abgewinkelten Balkone bieten eine sichere Auflage für den Deckel.

In Ausgestaltung der Erfindung ist vorgesehen, daß die Zungen und/oder Vorsprünge in Einschubrichtung des Deckels jeweils mit einer Auswölbung versehen sind. Der Abstand zwischen der Auflagefläche der Balkone und der Unterseite der Vorsprünge des Gehäuserandes ist durchweg so ausgebildet, daß der Deckel beim Einschieben von den Balkonen einerseits und den Vorsprüngen andererseits durch Reibung gehalten wird. Durch Vorsehen einer derartigen Auswölbung an den Zungen wird der Sitz zwischen dem Deckel und den entsprechnden Flächen der Balkone und der Vorsprünge erheblich verbessert. Je nach den gegebenen Verhältnissen können derartige Auswölbungen entweder an den Zungen oder an den Balkonen oder an den Zungen und Balkonen ausgebildet sein.

Eine weitere Verbesserung des Sitzes besteht in Ausgestaltung der Erfindung darin, daß die Zungen und/oder die Vorsprünge an den einander berührenden Stellen mit plastisch verformbaren Nocken versehen sind. Durch eine derartige Zinnenverriegelung des Deckels werden beim Arretieren bzw. Verschieben des Deckels die Nocken plastisch verformt, so daß eine maximale Vorspannkraft anliegt.

In weiterer Ausgestaltung der Erfindung ist vorgesehen, daß die von Zungen freien Kanten des Deckels jeweils mit mindestens einer Verriegelungsnase versehen sind. Derartige Verriegelungsnasen können z.B. auf einfache Weise durch Hochbiegen eines durch zwei Einschnitte gebildeten Deckelteiles gebildet werden. Derartige Verriegelungsnasen bewirken, daß der Deckel nach dem Einschieben nicht mehr aus seiner Lage herausfallen kann.

Die Erfindung bezieht sich ferner auf ein Verfahren zur Abschirmung von elektrischen Bauelementen, die auf einer von einem derartigen Gehäuse umschlossenen Leiterplatte angeordnet sind. Ein derartiges Verfahren ist dadurch gekennzeichnet,
- daß die Leiterplatte in das Gehäuse eingesetzt und mit den Seitenwänden des Gehäuses verlötet wird,
- daß der Deckel mit seinen Aussparungen über die Vorsprünge so in das Gehäuse eingesetzt wird, daß er zunächst teilweise auf den Balkonen aufliegt,
- daß der Deckel so weit in Einschubrichtung verschoben wird, daß die Zungen die Vorsprünge untergreifen, die in Einschubrichtung liegende Deckelkante den entsprechenden Gehäuserand untergreift und die gegenüberliegende Deckelkante in die Gehäuseöffnung einschnappt, und
- daß der Deckel in Gegenrichtung so weit verschoben wird, daß die freie Deckelkante den zugehörigen Gehäuserand untergreift.

Ein derartiges Verfahren ermöglicht eine einfache Abschirmmöglichkeit für Bauelemente, die auf einer Leiterplatte innerhalb des Gehäuses untergebracht sind. Bei Bedarf kann der Deckel leicht wieder gelöst werden, indem nach Verschieben die eine Deckelkante hochgebogen und danach der Deckel herausgezogen wird.

In der Zeichnung ist in Fig. 1 bis 3 ein Ausführungsbeispiel des Gegenstandes gemäß der Erfindung schematisch dargestellt.
Fig. 1 zeigt in einer perspektivischen Darstellung ein Gehäuse und einen zugehörigen Deckel in einer auseinandergezogenen Darstellung,
Fig. 2 zeigt einen Schnitt II-II nach Fig. 1 mit gestrichelt eingezeichnetem Deckel, und
Fig. 3 zeigt einen Schnit III-III nach Fig. 1 mit gestrichelt eingezeichnetem Deckel.

Fig. 1 zeigt ein Tuner-Gehäuse 10, welches zur Aufnahme einer mit Bauelementen 11 versehenen Leiterplatte 12 ausgebildet ist. Die Leiterplatte 12 ist innerhalb des Gehäuses 10 an ihren Kanten mit den Seitenwänden 10a verlötet. Die Unterseite des Gehäuses ist im Ausführungsbeispiel offen dargestellt und kann durch einen nicht dargestellten Deckel verschlossen werden, der mit am Rand angebrachten Zungen die entsprechenden Seitenwände 10a des Gehäuses übergreift. Die Oberseite des Gehäuses 10 besitzt eine Gehäuseöffnung 13, die durch einen Deckel 14 verschlossen werden kann. Das Gehäuse besitzt einen nach innen abgewinkelten Gehäuserand 15, der an seinen beiden gegenüberliegenden Kanten 15a, 15b nach innen weisenden Vorsprünge 16 aufweist. Die Vorsprünge 16 liegen in ein und derselben Ebene mit dem Gehäuserand 15. Neben den Vorsprüngen 16 sind nach unten und nach innen abgewinkelte Balkone 17 erkennbar, die in einer Ebene unterhalb der Ebene der Vorsprünge 16 liegen.

Der Deckel 14 besitzt an zwei gegenüberliegenden Seiten durch Aussparungen 18 gebildete Zungen 19, die in Richtung der benachbarten Seitenkanten des Deckels 14 mit Auswölbungen 20 versehen sind. Diese tragen plastisch verformbare Nocken 21.

Der Deckel ist in seiner Längsrichtung etwas größer als die Gehäuseöffnung 13. Zum Verschließen der Öffnung 13 wird der Deckel 14 zunächst mit seinen Aussparungen 18 über die Vorsprünge 16 so in das Gehäuse 10 eingesetzt, daß die eine Deckelkante 14a in Pfeilrichtung 22 unter den einen Gehäuserand 15c geschoben werden kann. Bei dem Einschieben untergreifen die Zungen 19 die Vorsprünge 16, wobei die eine Deckelkante 14a den Gehäuserand 15c untergreift. Dabei schnappt die andere Gehäusekante 14b in die Gehäuseöffnung 13 ein. Der Deckel 14 liegt jetzt voll auf den Balkonen 17 auf. Danach wird der Deckel in Gegenrichtung so weit verschoben, daß beide Deckelkanten 14a, 14b die entsprechenden Gehäuseränder 15c, d untergreifen. Damit ist der Deckel über Verriegelungsnasen 23 gesichert und das Gehäuseinnere durch den Deckel strahlungssicher abgeschirmt. An der vorderen Gehäuseaußenwand 10a sitzt eine Kontaktleiste 24, die mit Anschlußkontakten 25 versehen ist, die die Seitenwand isoliert durchdringen und mit der Leiterplatte 12 verbunden sind. Bei bisherigen Tunern liegt eine derartige Kontaktleiste innerhalb des Gehäuses und beansprucht daher relativ viel Platz, der für die Leiterplatte mit den elektronischen Bauelementen verloren ist. Da bei diesen bekannten Tuner das Gehäuse mit einem Deckel verschlossen wird, der mit auf den Seitenwandungen aufliegenden Klemmstegen versehen ist, kann bei diesen Tunern die Kontaktleiste nicht nach außen verlegt werden. Die erfindungsgemäße Bauart hat somit einen weiteren Vorteil, daß durch die Verlegung der Kontaktleiste nach außen nunmehr der wirksame Innenraum vergrößert wurde und somit besser ausgenutzt werden kann.

## Patentansprüche

1. Abschirmgehäuse (10) für im Innern angeordnete elektrische Bauelemente (11) mit einer durch einen Deckel (14) verschlossenen Geäuseöffnung (13), die einen umlaufenden, nach innen abgewinkelten Gehäuserand (15) aufweist, wobei durch Aussparungen (18) gebildete, nach außen ragende Zungen (19) des Deckels (14) nach innen ragende Vorsprünge (16) des Gehäuserandes (15) untergreifen, dadurch gekennzeichnet,
- daß die Zungen (19) des Deckels (14) und die Vorsprünge (16) des Gehäuserandes (15) jeweils an zwei gegenüberliegenden Seiten angeordnet sind,
- daß die Zungen (19) des Deckels (14) mit dem Deckel in ein und derselben Ebene liegen,
- daß neben den Vorsprüngen (16) nach unten und innen abgewinkelte Balkone (17) zur Auflage des Deckels (14) vorgesehen sind und
- daß die beiden von Zungen (19) freien Deckelkanten (14a, b) die beiden entsprechenden Gehäuseränder (15c, d) untergreifen.

2. Abschirmgehäuse nach Anspruch 1, dadurch gekennzeichnet, daß die Zungen (19) und/oder die Vorsprünge (16) jeweils mit einer in Einschubrichtung (22) des Deckels (14) verlaufenden Auswölbung (20) versehen sind.

3. Abschirmgehäuse nach Anspruch 1 oder 2, dadurch gekennzeichnet, daß die Zungen (19) und/oder die Vorsprünge (16) an den einander berührenden Stellen mit plastisch verformbaren Nocken (21) versehen sind.

4. Abschirmgehäuse nach einem der Ansprüche 1 bis 3, dadurch gekennzeichnet, daß die von Zungen (19) freien Deckelkanten (14a, b) jeweils mit mindestens einer Verriegelungsnase (23) versehen sind.

5. Abschirmgehäuse nach Anspruch 4, dadurch gekennzeichnet, daß die Verriegelungsnasen (23) jeweils durch Hochbiegen eines durch zwei Einschnitte gebildeten Deckelteils gebildet werden.

6. Abschirmgehäuse nach einem der Ansprüche 1 bis 5, gekennzeichnet durch die Anwendung bei einem HF-Modul, z.B. einem Tuner, mit einer von dem Gehäuse (10) umschlossenen Leiterplatte (12), deren Kontaktanschlüsse (24) eine Seitenwand (10a) isoliert durchdringen und mit einer außen an dieser Seitenwand (10a) angebrachten Kontaktleiste (24) verbunden sind.

7. Verfahren zur Abschirmung von elektrischen Bauelementen (11), die auf einer von dem Gehäuse (10) umschlossenen Leiterplatte (12) angeordnet sind, dadurch gekennzeichnet,
- daß die Leiterplatte (12) in das Gehäuse (10) eingesetzt und mit den Seitenwänden (10a) verlötet wird,
- daß der Deckel (14) mit seinen Aussparungen (18) über die Vorsprünge (16) so in das Gehäuse (10) eingesetzt wird, daß er zunächst teilweise auf den Balkonen (17) aufliegt,
- daß der Deckel so weit in Einschubrichtung (22) verschoben wird, daß die Zungen (19) die Vorsprünge (16) untergreifen. die in Einschubrichtung (22) liegende Deckelkante (14a) den Gehäuserand (15c) untergreift und die andere Deckelkante (14b) in die Gehäuseöffnung (13) einschnappt, und
- daß der Deckel (14) in Gegenrichtung so weit verschoben wird, daß auch die freie Deckelkante (14b) den Gehäuserand (15d) untergreift.

## Claims

1. A screening housing (10) for electronic components (11) arranged therein, with an opening (13) of the housing that is closed with a lid (14) and which comprises a circumferential housing edge (15) which is flanged inwards, while outwardly projecting tongues (19) of the lid (14) defined by recesses (18) grip below inwardly extending projections (16) of the housing edge (15), characterized in that
- the tongues (19) of the lid (14) and the projections (16) of the housing edge (15) are arranged on two mutually opposed sides,
- the tongues (19) of the lid (14) lie in the same plane as the lid itself,
- ledges (17) bent inwards and into a lower plane are provided for supporting the lid (14) next to the projections (16), and
- the two edges (14a, b) of the lid (14) not having tongues (19) grip below the two corresponding housing edges (15c, d).

2. A screening housing as claimed in Claim 1, characterized in that the tongues (19) and/or projections (16) are each provided with a bulging shape (20) in the direction of insertion (22) of the lid (14).

3. A screening housing as claimed in Claim 1 or 2, characterized in that the tongues (19) and/or the projections (16) are provided with plastically deformable catches (21) in those locations which are in contact with one another.

4. A screening housing as claimed in any one of the Claims 1 to 3, characterized in that the edges (14a, b) of the lid (14) not having tongues (19) are each provided with at least one locking stud (23).

5. A screening housing as claimed in Claim 4, characterized in that the locking studs (23) are each formed through bending upwards of a lid portion defined by two incisions.

6. A screening housing as claimed in any one of the Claims 1 to 5, characterized by its use in an HF module, for example a tuner, with a printed circuit board (12) enclosed by the housing (10), the contact connections (24) of said board being passed with insulation through a side wall (10a) and being connected to a contact strip (24) which is provided on the outside of this side wall (10a).

7. A method of screening electric components (11) which are arranged on a printed circuit board (12) enclosed by the housing (10), characterized in that
- the printed circuit board (12) is inserted into the housing (10) and is soldered to the side walls (10a) thereof,
- the lid (14) is inserted into the housing (10) with its recesses (18) over the projections (16) so that it initially rests partly on the ledges (17),
- the lid (14) is shifted in the insertion direction (22) until the tongues (19) grip below the projections (16), the lid edge (14a) lying in the insertion direction (22) grips below the corresponding housing edge (15c), and the other lid edge (14b) is snapped home into the housing opening (13), and
- the lid (14) is shifted in opposite direction until the free lid edge (14b) also grips below the housing edge (15d).

## Revendications

1. Boîte de blindage (10) pour des composants électriques (11) disposés à l'intérieur de celui-ci avec une ouverture de boîte (13) fermée par un couvercle (14) qui présente un bord de boîte (15) périphérique et coudé vers l'intérieur, des languettes (19) du couvercle (14) débordant vers l'extérieur et formées par les évidements (18) saisissant par le dessous des épaulements (16) du bord de boîte (15) débordant vers l'intérieur,
caractérisée en ce
- que les languettes (19) du couvercle (14) et les épaulements (16) du bord de la boîte (15) sont respectivement disposés sur deux faces opposées,
- que les languettes (19) du couvercle 14 sont situées dans un seul et même plan avec le couvercle,
- qu'outre les épaulements (16), des balcons coudés vers le bas et vers l'intérieur (17) sont prévus en vue d'appliquer le couvercle (14) et
- que les deux bords de couvercle (14a, b) exempts de languettes (19) saisissent par le dessous les deux bords de boîte (15c, d) correspondants.

2. Boîte de blindage selon la revendication 1, caractérisée en ce que les languettes (19) et/ou les épaulements (16) sont dotés respectivement d'un renflement (20) s'étendant respectivement dans le sens d'introduction (22) du couvercle (14).

3. Boîte de blindage selon l'une des revendications 1 ou 2, caractérisée en ce que les languettes (19) et/ou les épaulements (16) sont dotés sur les faces en contact l'une avec l'autre d'ergots (21) déformables plastiquement.

4. Boîte de blindage selon l'une des revendications 1 à 3, caractérisée en ce que les bords de couvercle (14a, b) exempts de languettes (19) sont respectivement dotés d'au moins un taquet de verrouillage (23).

5. Boîte de blindage selon la revendication 4, caractérisée en ce que les taquets de verrouillage (23) sont respectivement formés par cambrage d'une partie de couvercle formée par deux encoches.

6. Boîte de blindage selon l'une des revendications 1 à 5 caractérisée par l'utilisation d'un module HF, par exemple un tuner, avec une carte à circuits imprimés (12) renfermée par la boîte (10) dont les bornes de contact (24) traversent une paroi latérale (10a) de manière isolée et sont reliées à une réglette de contact (24) appliquée à l'extérieur contre cette paroi latérale (10a).

7. Procédé de blindage de composants électriques (11) qui sont disposés sur une carte à circuits imprimés (12) renfermée par la boîte (10) caractérisé en ce
- que la carte à circuits imprimés (12) est insérée dans la boîte (10) et soudée aux parois latérales (10a),
- que le couvercle (14) est inséré avec ses évidements (18) sur les épaulements (16) dans la boîte (10) de telle sorte qu'il soit d'abord appliqué en partie sur les balcons (17),
- que le couvercle est inséré dans le sens d'introduction (22) jusqu'à ce que les languettes (19) saisissent les épaulements (16) par le dessous, le bord du couvercle (14a) situé dans le sens d'introduction (22) saisisse le bord de la boîte (15c) par le dessous et l'autre bord du couvercle (14b) s'encliquette dans l'ouverture de la boîte 13 et
- que le couvercle (14) est glissé dans la direction opposée jusqu'à ce que le bord libre du couvercle (14b) saisisse le bord de la boîte (15d) par le dessous.
